# EUROPÄISCHE PATENTSCHRIFT

(11) **EP 2 568 793 B1**
(45) Veröffentlichungstag und Bekanntmachung des Hinweises auf die Patenterteilung: **31.10.2018**
(21) Anmeldenummer: 12179661.9
(22) Anmeldetag: 08.08.2012
(51) Int. Cl.: H05K 7/20

(54) **Verfahren und Anordnung zum Klimatisieren eines Raumes**
Assembly and method for air conditioning a room
Procédé et agencement destinés à la climatisation d'une pièce

(30) Priorität: 09.09.2011 DE 202011051248 U
(43) Veröffentlichungstag der Anmeldung: 13.03.2013
(73) Patentinhaber: Weiss Klimatechnik GmbH, 35447 Reiskirchen-Lindenstruth (DE)
(72) Erfinder:
(74) Vertreter: Stoffregen, Hans-Herbert

(56) Entgegenhaltungen:
- EP-A2- 2 278 231
- EP-A2- 2 317 236
- DE-U1-202004 003 309
- DE-U1-202009 002 033
- DE-U1-202011 000 591
- US-A1- 2008 185 446

## Beschreibung

Die Erfindung bezieht auf ein Verfahren zum Klimatisieren eines ersten Raums unter Verwendung einer eine Saug- und eine Druckseite aufweisende Ventilatoreinrichtung mit den Raum begrenzenden Kopf- und Seitenwandungen, einer Durchbrechungen aufweisenden und einen Hohlraum begrenzenden Bodenwandung sowie einen fluiddurchströmten, insbesondere von Kaltwasser durchströmten, Wärmetauscher, der eine den ersten Raum von einem zweiten Raum abtrennende Seitenwandung oder ein Abschnitt dieser ist, wobei der erste Raum durch wärmeerzeugende Geräte in zumindest einen Kaltraumbereich und einen Warmraumbereich unterteilt wird, wobei über die Saugseite der Ventilatoreinrichtung Luft aus dem Warmbereich angesaugt werden kann und über die Druckseite Luft dem Kaltraumbereich zugeführt werden kann.

Ferner bezieht sich die Erfindung auf eine Klimatisierungsanordnung umfassend einen zu klimatisierenden ersten Raum mit diesen begrenzenden Kopf- und Seitenwandungen und einer Durchbrechungen aufweisenden und einen Hohlraum begrenzenden Bodenwandung, einen fluiddurchströmten, insbesondere von Kaltwasser durchströmten, Wärmetauscher, der eine einen zweiten Raum abtrennende Seitenwandung oder ein Abschnitt dieser ist, in dem ersten Raum durch wärmeerzeugende Geräte voneinander getrennten zumindest einen Kaltraumbereich und zumindest einen Warmraumbereich sowie zumindest eine insbesondere in dem Hohlraum angeordnete eine Saugseite und eine Druckseite aufweisende Ventilatoreinrichtung, wobei von der Saugseite Luft aus dem Warmbereich angesaugt und über die Druckseite Luft dem Kaltraumbereich zugeführt werden kann.

Eine entsprechende Anordnung ist der DE-20 2009 013 664 U1 (= EP 2 317 236 A2) zu entnehmen. Durch die Anordnung des Wärmetauschers als Raumbegrenzung bzw. Abschnitt einer Raumbegrenzung kann der die wärmeerzeugenden Geräte aufweisende Raum energetisch günstig gekühlt werden. Gleichzeitig erfolgt eine problemlose Wartung des Wärmetauschers, da dieser auf der einen Seite von dem die wärmeerzeugende Geräte aufweisenden Raum und auf der raumabgewandten Seite von einem weiteren Raum oder Gang begrenzt wird, in dem Wartungsarbeiten durchgeführt werden können. Dabei ist der zweite Raum über Durchbrechungen in der Bodenwandung mit dem von der Bodenwandung begrenzten Hohlraum verbunden, in dem zumindest eine Ventilatoreinrichtung angeordnet sein kann.

Der DE 10 2009 030 114 A1 (= EP 2 278 231 A2), DE 200 23 882 U1, DE 20 2011 000 591 U1 sind ebenfalls Klimatisierungsgeräte bzw. Klimatisierungsanordnungen zu entnehmen, bei denen über Öffnungen eines Hohlbodens Luft in einen zu klimatisierenden Raum strömt, um im reinen Umluftbetrieb in dem Raum vorhandene wärmeerzeugende Geräte zu kühlen.

Der DE 20 2009 002 033 U1 ist eine Anordnung zur Klimatisierung eines Raumes zu entnehmen, in dem ein Klimatisierungsgerät angeordnet ist. Der Raum kann im Umluft-, reinem Außenluft- und Mischbetrieb gekühlt werden. Dabei wird stets der in dem Klimatisierungsgerät vorhandene Wärmetauscher von der dem Raum zuzuführenden Luft durchströmt.

Eine Cluster-Kühlung ist der DE 20 2004 003 209 U1 zu entnehmen. Durch eine perforierte Frontseite eines doppelwandigen Gehäuses, in dem sich elektronische Bauteile befinden, wird Kaltluft angesaugt. Die erwärmte Luft wird mit Hilfe von Ventilatoren, die an der Rückwand des Gehäuses angebracht sind, nach außen in einen an dem Gehäuse angebrachten Sammelbehälter geführt.

Um einen Rechnerraum zu kühlen, sieht die US 2008/0185446 A1 außerhalb des Raums angeordnete Klimatisierungsgeräte vor.

Der vorliegenden Erfindung liegt die Aufgabe zugrunde, ein Verfahren und eine Klimatisierungsanordnung zuvor genannter Art so weiterzubilden, dass eine energetisch optimierte Kühlung bei konstruktiv geringem Aufwand möglich ist.

Auch soll bei starker Wärmelast auch dann im erforderlichen Umfang eine Kühlung ermöglicht werden, wenn der Wärmetauscher flächenmäßig nicht auf die Wärmelast ausgelegt sein sollte.

Verfahrensmäßig wird die Aufgabe im Wesentlichen dadurch gelöst, dass der erste Raum in Abhängigkeit von der in diesem einzustellenden Temperatur im Umluftbetrieb, im reinen Außenluftbetrieb oder im Mischbetrieb klimatisiert wird, wobei im reinen Außenluft- und im Mischbetrieb Fortluft über eine mittels einer ersten Verschlusseinrichtung verschließbare Fortluftöffnung aus dem ersten Raum oder aus dem Hohlraum fortgeführt wird und Außenluft über eine in dem zweiten Raum vorhandene mittels einer zweiten Verschlusseinrichtung verschließbare Außenluftöffnung zugeführt wird, wobei bei reinem Außenluftbetrieb die Außenluft unter Umgehung des Wärmetauschers dem ersten Raum zugeführt wird, wobei im Umluftbetrieb die Klimatisierung mit durch den Wärmetauscher strömender Außenluft gemischt wird.

Sofern die wärmeerzeugenden Geräte kopfseitig verschlossene Warmgänge bildende Warmraumbereiche begrenzen, ist vorgesehen, dass bei reinem Außenluftbetrieb die Außenluft unter Umgehung des Wärmetauschers von dem zweiten Raum dem ersten Raum zugeführt wird. Hierdurch ist eine energetisch besonders günstige Betriebsweise möglich. Des Weiteren sollte bei einer diesbezüglichen Anordnung der wärmeerzeugenden Geräte bei reinem Außenluftbetrieb der Hohlboden gegenüber dem zweiten Raum verschlossen sein, so dass die über die Ventilatoreinrichtung über die Warmgänge angesaugte Außenluft strömungstechnisch ausschließlich der in dem Hohlboden vorhandenen Fortluftöffnung zugeführt wird.

Sind die wärmeerzeugenden Geräte derart angeordnet, dass diese kopfseitig verschlossene Kaltgänge begrenzen, geht die Fortluftöffnung von dem ersten Raum aus.

Eine Klimatisierungsanordnung der eingangs genannten Art zeichnet sich dadurch aus, dass der Hohlraum oder der erste Raum mit einer verschließbaren ersten Verschlusseinrichtung für Fortluft verbunden ist oder eine solche aufweist, dass der zweite Raum mit einer verschließbaren zweiten Verschlusseinrichtung für Außenluft verbunden ist oder diese aufweist und die Außenluft mittels der Ventilatoreinrichtung in den Kaltraumbereich angesaugt wird und dass der erste Raum in Abhängigkeit von der in dem ersten Raum einzustellenden Temperatur im Umluftbetrieb, im reinen Außenluftbetrieb oder im Mischbetrieb klimatisierbar ist, wobei bei reinem Außenluftbetrieb die Außenluft unter Umgehung des Wärmetauschers dem ersten Raum zugeführt wird, wobei im Umluftbetrieb die Klimatisierung mit durch den Wärmetauscher strömender Luft erfolgt, und wobei im Mischbetrieb ein Teil der Abluft mit zu strömender Außenluft gemischt wird.

Abweichend von bekannten Lösungen besteht die Möglichkeit, unter Nutzung von Außenluft unter Berücksichtigung von der Außenlufttemperatur den Raum zu klimatisieren. So kann eine 100 Prozent freie Kühlung dann erfolgen, wenn die Außentemperatur ausreicht, den zu klimatisierenden Raum in hinreichendem Umfang zu kühlen, so dass die wärmeerzeugenden Geräte in erforderlichem Umfang entwärmt werden. Dabei kann bei zu niedriger Außentemperatur dieser Abluft beigemischt werden. Erfolgt eine 100 Prozent freie Kühlung, so wird die Abluft ausschließlich über die Fortluftöffnung abgeführt, ohne dass ein Durchströmen des Wärmetauschers bzw. des von dem Wärmetauscher abgetrennten zweiten Raums erfolgt, der z. B. ein Wartungsgang sein kann. Bei Mischbetrieb wird ein Teil der Abluft über die Fortluftöffnung abgeführt und dem verbleibendem Teil zuströmende Außenluft zugemischt, wobei die Abluft gegebenenfalls den Wärmetauscher durchströmen kann. Erfolgt eine Kühlung ausschließlich über den Wärmetauscher, so wird sowohl die die Außenluft zuführende Öffnung als auch die Fortluftöffnung verschlossen.

Somit sieht die Erfindung vor, dass der zu klimatisierende Raum mit Außenluft und Abluft oder ausschließlich mit Außenluft oder ausschließlich mit durch den Wärmetauscher strömende Abluft (Umluft) klimatisierbar ist.

Ferner ist vorgesehen, dass die den Wärmetauscher enthaltende Seitenwandung eine verschließbare dritte Verschlusseinrichtung für die Außenluft aufweist, über die Außenluft über den Kaltraumbereich und sodann den Warmraumbereich zu der ersten Verschlusseinrichtung strömt.

Insbesondere ist vorgesehen, dass der erste Raum mehrere von den wärmeerzeugenden Geräten begrenzte kopfseitig verschlossene Gänge bildende Warmraum- bzw. Kaltraumbereiche aufweist und dass vorzugsweise jedem Gang zumindest eine in dem Hohlraum angeordnete Ventilatoreinrichtung zugeordnet ist.

Die Verschlusseinrichtungen selbst sind insbesondere temperaturgeregelt, um diese im erforderlichen Umfang zu öffnen bzw. zu schließen.

Weitere Einzelheiten, Vorteile und Merkmale der Erfindung ergeben sich nicht nur aus den Ansprüchen, den diesen zu entnehmenden Merkmalen -für sich und/oder in Kombination -, sondern auch aus der nachfolgenden Beschreibung eines der Zeichnung zu entnehmenden bevorzugten Ausführungsbeispiels.

Es zeigen:
- Fig. 1: eine erste Anordnung zum Klimatisieren eines Raumes im Mischbetrieb,
- Fig. 2: die Anordnung gemäß Fig. 1 zum Klimatisieren des Raums bei 100 % freier Kühlung,
- Fig. 3: die Anordnung gemäß Fig. 1 zum Klimatisieren des Raums bei 0 % freier Kühlung,
- Fig. 4: eine zweite Anordnung zum Klimatisieren eines Raumes im Mischbetrieb,
- Fig. 5: die Anordnung gemäß Fig. 4 zum Klimatisieren des Raums bei 100 % freier Kühlung und
- Fig. 6: die Anordnung gemäß Fig. 1 zum Klimatisieren des Raums bei 0 % freier Kühlung.

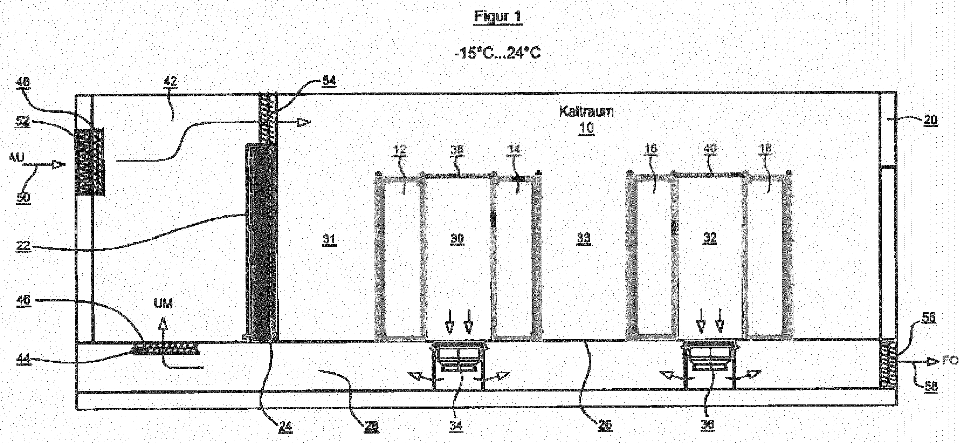

In den Fig. 1-3 ist rein prinzipiell eine erste Anordnung dargestellt, um einen ersten Raum 10, in dem in Reihen 12, 14, 16, 18 angeordnete wärmeerzeugende Geräte angeordnet sind, zu kühlen. Der erste Raum 10 wird kopf- und umfangsseitig von Wandungen begrenzt, von denen in den Figuren Seitenwandungen 20, 22 rein prinzipiell angedeutet sind. Dabei ist die Seitenwandung 22 zumindest abschnittsweise als Wärmetauscher 24 ausgebildet, der gehäuselos in der Seitenwandung 22 integriert ist. Insoweit wird auf eine Konstruktion verwiesen, wie diese zum Beispiel der DE-U-20 2009 013 664 zu entnehmen ist.

Der erste Raum 10 wird von einem Durchbrechungen aufweisenden Boden 26 begrenzt, der einen Zwischen- oder Hohlboden 28 abdeckt. Die Durchbrechungen im Boden 26 sind in den Bereichen vorgesehen, in denen die wärmeerzeugenden Geräte 12, 14, 16, 18 Warmraumbereiche 30, 32 begrenzen, so dass aus diesen über Ventilatoreinrichtungen 34, 36 die warme Abluft abgesaugt werden kann. Die Warmraumbereiche 30, 32 werden technisch als Warmgänge bezeichnet. Kaltgänge 31, 33 sind Bereiche des Raums 10, die außenseitig die Reihen 12, 14, 16, 18 begrenzen.

Zur Bildung der Warmgänge 30, 32 werden die wärmeerzeugenden Geräte 12, 14, 16, 18 in sogenannten Racks angeordnet. Die Gänge 30, 32 sind kopfseitig verschlossen. Die entsprechenden Elemente sind mit den Bezugszeichen 38 und 40 gekennzeichnet.

Wird in der zeichnerischen Darstellung jedem Warmgang 30, 32 eine Ventilatoreinrichtung 34, 36 zugeordnet, so kann gegebenenfalls eine Ventilartoreinrichtung mehreren Warmgängen oder mehrere Ventilatoreinrichtungen einem einzigen Warmgang zugeordnet sein, ohne dass die Erfindung verlassen wird.

Da die Warmgänge 30, 32 deckenseitig verschlossen (Elemente 38, 40) sind, wird den ersten Raum 10 durchströmende gekühlte Luft über die Kaltgänge 31, 33 durch die in den Reihen 12, 14, 16, 18 angeordneten wärmeerzeugenden Geräte hindurch zu den Warmgängen 30, 32 mittels der Ventilatoreinrichtung 34, 36 gesaugt, um die erforderliche Entwärmung zu erreichen.

Die Seitenwandung 22 mit dem integrierten Wärmetauscher 24 begrenzt auf der dem Raum 10 abgewandten Seite einen zweiten Raum 42, der die Funktion eines Wartungsgangs ausüben kann, um den Wärmetauscher 24 warten zu können. In dem zweiten Raum 42 können des weiteren Steuer- bzw. Regelgeräte oder sonstige für die Funktion des Wärmetauschers notwendige Einrichtungen vorhanden sein.

Damit aus dem Raum 10 über die Ventilatoreinrichtung 34, 36 strömende Luft dem Wärmetauscher 24 zugeführt werden kann, weist der zweite Raum 42 in seinem Boden eine über eine als vierte Verschlusseinrichtung 44 bezeichnete Verschlusseinrichtung verschließbare Öffnung 46 auf, wie dies prinzipiell den Figuren zu entnehmen ist.

Erfindungsgemäß ist der zweite Raum 42 des Weiteren über eine als zweite Verschlusseinrichtung 48 bezeichnete Verschlusseinrichtung wie Klappenmechanismus mit der Außenluft verbunden, wie durch den Pfeil 50 angedeutet wird. Zwischen der Verschlusseinrichtung 48 und der Außenluft kann ein Filter 52 angeordnet sein.

Damit in nachstehend beschriebener Weise die über die zweite Verschlusseinrichtung 48 strömende Außenluft in den zu klimatisierenden ersten Raum 10 strömen kann, ist in der Seitenwandung 22 eine als dritte Verschlusseinrichtung bezeichnete Verschlusseinrichtung 54 vorgesehen. Die zweite und dritte Verschlusseinrichtung 48, 54 können im erforderlichen Umfang geregelt geschlossen oder geöffnet werden, je nachdem, in welcher Betriebsweise der Raum 10 zu kühlen ist, wie dies nachstehend erläutert wird.

Des Weiteren ist der Hohlboden 28 mit einer als erste Verschlusseinrichtung bezeichneten Verschlusseinrichtung 56 im erforderlichen Umfang verschließbar, so dass über diese Fortluft strömen kann (Pfeil 58).

Dabei ist die Fortluftöffnung vorzugsweise in Bezug auf die Seitenwandung 22, in der der Wärmetauscher integriert ist, im Bereich der zu dieser gegenüberliegenden Seitenwandung 20 angeordnet.

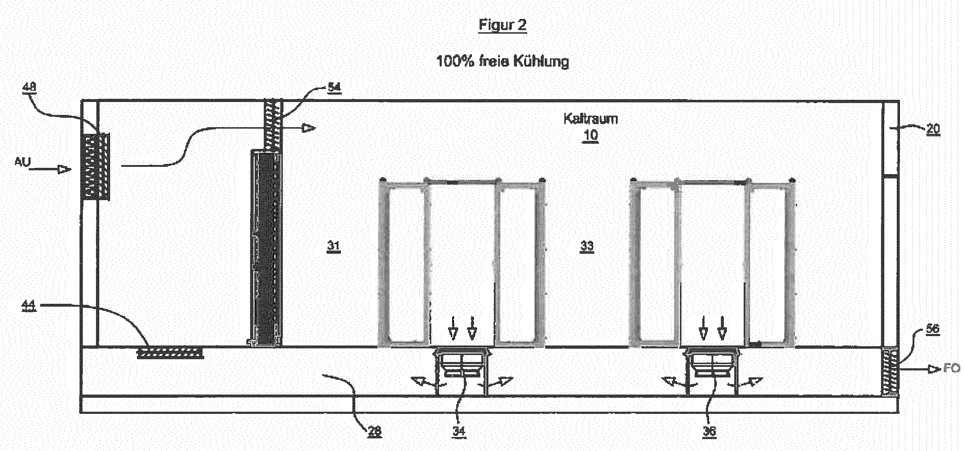

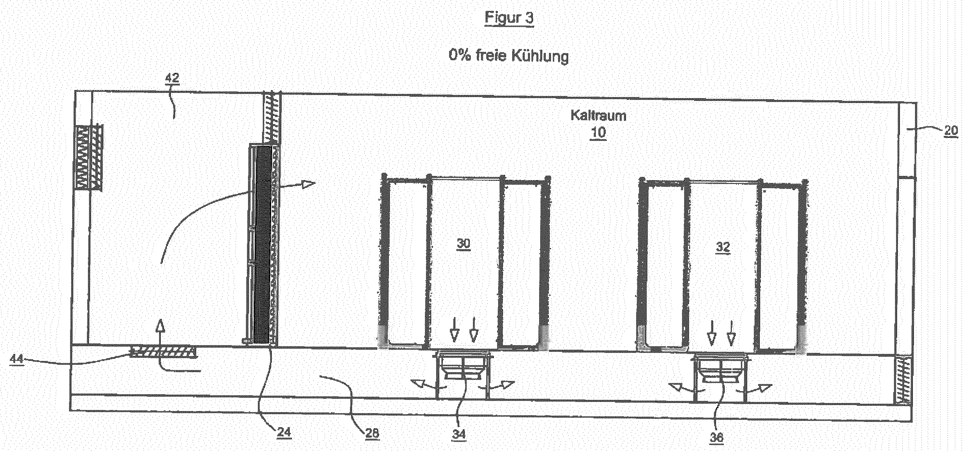

Aufgrund der erfindungsgemäßen Konstruktion und der Anordnungen der Verschlusseinrichtungen 44, 48, 54, 56 besteht die Möglichkeit, den Raum 10 im Mischbetrieb (Fig. 1), bei 100 % freier Kühlung (Fig. 2), also ausschließlich mit Außenluft, oder mit 0 % freier Kühlung, also ausschließlich im Umluftbetrieb (Fig. 3) zu kühlen.

Im Mischbetrieb strömt über die Ventilatoreinrichtungen 34, 36 aus den Warmgängen 30, 32 abgesaugte Ab- oder Umluft über die vierte Verschlusseinrichtung 44 in den zweiten Raum 42 und sodann bei geschlossener dritter Verschlusseinrichtung 54 über den Wärmetauscher 22 in den Raum 10. Ferner strömt in den zweiten Raum 42 Außenluft, die mit der Abluft den Wärmetauscher 24 durchsetzt. Des Weiteren strömt Fortluft über die erste Verschlusseinrichtung 56 nach außen. Entsprechend der Menge der Fortluft strömt in den zweiten Raum 42 über die zweite Verschlusseinrichtung 48 Außenluft, die erwähntermaßen mit der Abluft (Umluft) vermischt wird. In Abhängigkeit von der einzustellenden Temperatur strömt die Umluft durch den Wärmetauscher 24, ohne dass ein Kühlen erfolgen muss.

Die Umluft wird somit mit der Außenluft in einem Umfang vermischt, dass der im Wesentlichen einen Kaltraum bildende erste Raum 10 und somit die Kaltgänge 31, 32 mit einer Luft durchströmt werden, die die erforderliche Entwärmung der wärmeerzeugenden Geräte, die in den Reihen 12, 14, 16, 18 angeordnet sind, sicherstellt.

Entsprechend der Fig. 2 (100 % freie Kühlung) wird ausschließlich Außenluft über die zweite und dritte Verschlusseinrichtungen 48, 54 in den Raum 10 und somit die Kaltgänge 31, 33 und Warmgänge 30, 32 über die Ventilatoreinrichtungen 34, 36 angesaugt, um die Abluft sodann über die erste Verschlusseinrichtung 56 als Fortluft abzuführen. Die zwischen dem Hohlraum 28 und dem zweiten Raum 42 verlaufende vierte Verschlusseinrichtung 44 ist sodann geschlossen.

Ein reiner Umluftbetrieb ist der Fig. 3 zu entnehmen. Dabei wird die aus den Warmgängen 30, 32 über die Ventilatoreinrichtungen 34, 36 angesaugte Abluft über die vierte Verschlusseinrichtung 44 dem zweiten Raum 42 zugeführt, um sodann zur Kühlung durch den Wärmetauscher 24 in den Kaltraum 10 zu strömen. Die erste und zweite Verschlusseinrichtung 45, 48 sind geschlossen.

Bei dem fluiddurchströmten Wärmetauscher 24 handelt es sich insbesondere um einen von Kaltwasser durchströmten Wärmetauscher.

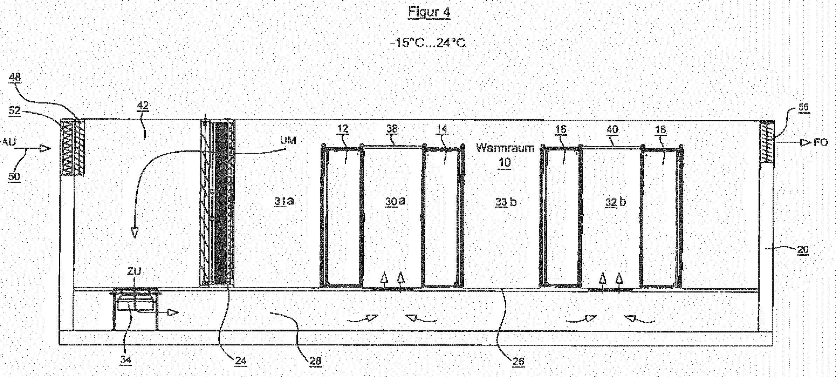

Steht nach dem Ausführungsbeispiel der Fig. 1 bis 3 der jeweilige Warmgang 30, 32 mit dem Hohlboden 28 in Verbindung, wohingegen der Boden 26 außerhalb der Warmgänge, die durch die Reihen 12, 14, 16, 18 begrenzt sind, geschlossen ist, so wird nach dem Ausführungsbeispiel der Fig. 4 bis 6 eine Vertauschung vorgenommen, d. h., dass die Reihen 12, 14 bzw. 16, 18 Kaltgänge 30a, 32b begrenzen, so dass sich diese außerhalb der Warmraumbereiche und somit der Warmgänge 31 a, 33 b befinden, d. h., dass der erste Raum 10 dem Grunde nach ein Warmraum ist, in dem die von den Reihen 12, 14, 16, 18 begrenzten Kaltgänge 30 a, 32 b angeordnet sind, die - wie die Warmgänge 30, 32 - mit Abdeckungen 38, 40 kopfseitig verschlossen sind. Da sowohl für die Anordnung gemäß der Fig. 1 bis 3 als auch für die der Fig. 4 bis 6 grundsätzlich gleiche Elemente verwendet werden, werden entsprechend gleiche Bezugszeichen benutzt.

Wie die die Strömung der Luft symbolisierenden Pfeile verdeutlichen, wird über den Ventilator 34 Luft aus dem zweiten Raum 42 angesaugt, damit diese die Öffnungen in dem Zwischenboden 26 durchdringen und in die Kaltgänge 30 a, 32 b strömen kann, von denen aus die Kaltluft die wärmeerzeugenden Geräte durchströmt, um diese zu entwärmen.

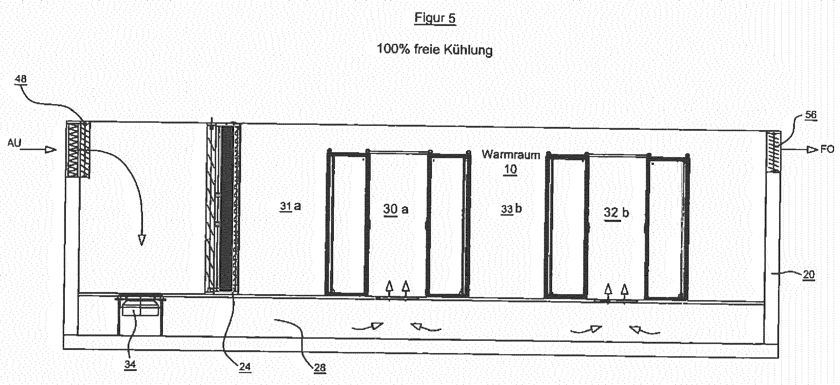

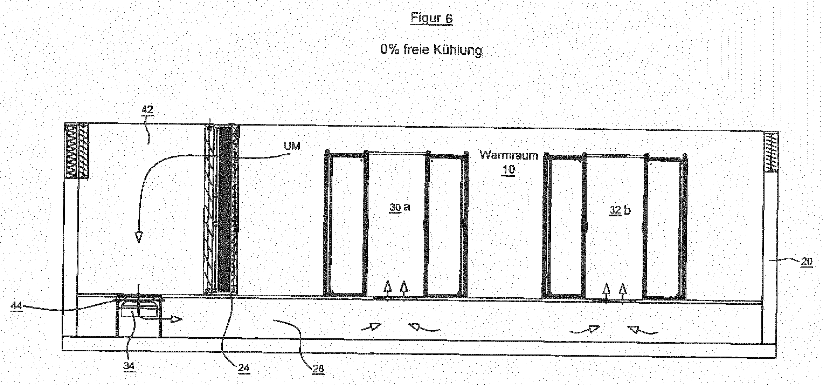

Um gleichfalls die Anordnung gemäß der Fig. 4 bis 6 sowohl im Mischbetrieb (Fig. 4), als auch bei 100 % freier Kühlung (Fig. 5) bzw. in reinem Umluftbetrieb (0 % freie Kühlung; Fig. 6) betreiben zu können, sind folgende Maßnahmen getroffen.

Da im Misch- bzw. reinen Außenluftbetrieb die Fortluft nicht aus dem Hohlboden 28 abgeführt werden darf, befindet sich in der dem Wärmetauscher 24 gegenüberliegenden Seitenwandung 20 eine über das erste Verschlusselement 56 verschließbare Fortluftöffnung. Der zweite Raum 42 weist die durch die zweite Verschlusseinrichtung 48 verschließbare Außenluftöffnung auf, die außenseitig von dem Filter 52 abgedeckt sein kann. Im Vergleich zum Ausführungsbeispiel der Fig. 1 bis 3 ist in der den Wärmetauscher 24 aufweisenden Seitenwandung keine Verschlusseinrichtung vorgesehen. Auch befindet sich zwischen dem zweiten Raum 42 und der Saugseite des Ventilators 34 keine Verschlusseinrichtung.

Soll eine Klimatisierung ausschließlich bei 100 % freier Kühlung erfolgen, wird die erste Verschlusseinrichtung 56 für die Fortluft und die zweite Verschlusseinrichtung 48 für die Außenluft im erforderlichen Umfang geöffnet, um sodann Außenluft über den Ventilator 34 zu saugen und den Kaltgängen 30a, 32b zuzuführen, von denen die Kaltluft die in den Reihen 12, 14, 16, 18 angeordneten wärmeerzeugenden Geräte durchströmt. Erwärmte Luft wird sodann über die Fortluftöffnung aus dem ersten Raum 10 abgeführt.

Bei einem Mischbetrieb (Fig. 4) wird über den Wärmetauscher 24 strömende Umluft (UM) mit Außenluft vermischt, um sodann entsprechend dem Außenluftanteil erwärmte Luft aus dem ersten Raum 10 über die Fortluftöffnung abzuführen.

In einem reinen Umluftbetrieb, also bei 0 % freier Kühlung (Fig. 6), wird entsprechend dem Stand der Technik im Raum 10 Luft über den Wärmetauscher 24 abgesaugt, um sodann die über den Ventilator 34 strömende gekühlte Luft den Kaltgängen 30a, 32b zuzuführen. Die durch die in den Reihen 12, 14, 16, 18 angeordneten wärmeerzeugenden Geräte strömende Luft wird sodann aus den Warmgängen 31a, 33b über den Wärmetauscher 24 wieder abgesaugt. Die erste und zweite Verschlusseinrichtung 56, 48 sind geschlossen.

## Patentansprüche

1. Verfahren zum Klimatisieren eines ersten Raums (10) unter Verwendung einer eine Saug- und eine Druckseite aufweisende Ventilatoreinrichtung (34, 36) mit den Raum begrenzenden Kopf- und Seitenwandungen (20, 22), einer Durchbrechungen aufweisenden und einen Hohlraum (28) begrenzenden Bodenwandung (26) sowie einen fluiddurchströmten, insbesondere von Kaltwasser durchströmten, Wärmetauscher (24), der eine den ersten Raum von einem zweiten Raum (42) abtrennende Seitenwandung (22) oder ein Abschnitt dieser ist, wobei der erste Raum durch wärmeerzeugende Geräte in zumindest einen Kaltraumbereich (31, 33, 30a, 32b) und einen Warmraumbereich (30, 32, 31a, 33b) unterteilt wird, wobei über die Saugseite der Ventilatoreinrichtung Luft aus dem Warmbereich angesaugt werden kann und über die Druckseite Luft dem Kaltraumbereich zugeführt werden kann, **dadurch gekennzeichnet,**
**dass** der erste Raum (10) in Abhängigkeit von der in diesem einzustellenden Temperatur im Umluftbetrieb, im reinen Außenluftbetrieb oder im Mischbetrieb klimatisiert wird, wobei im reinen Außenluft- und im Mischbetrieb Fortluft über eine mittels einer ersten Verschlusseinrichtung (56) verschließbare Fortluftöffnung aus dem ersten Raum (10) oder aus dem Hohlraum (28) fortgeführt wird und Außenluft über eine in dem zweiten Raum (42) vorhandene mittels einer zweiten Verschlusseinrichtung (48) verschließbare Außenluftöffnung zugeführt wird, wobei bei reinem Außenluftbetrieb die Außenluft unter Umgehung des Wärmetauschers dem ersten Raum (10) zugeführt wird, wobei im Umluftbetrieb die Klimatisierung mit durch den Wärmetauscher strömender Luft erfolgt, und wobei im Mischbetrieb ein Teil der Abluft mit zu strömender Außenluft gemischt wird.

2. Verfahren nach Anspruch 1,
**dadurch gekennzeichnet,**
**dass** wärmeerzeugende Geräte in kopfseitig verschlossene Gänge (30, 32) begrenzenden Reihen (12, 14, 16, 18) angeordnet werden und dass bei den Warmraumbereich bildenden Gängen die erste die Fortluftöffnung verschließende Verschlusseinrichtung (56) vom Hohlraum (28) ausgeht.

3. Verfahren nach Anspruch 1 oder 2,
**dadurch gekennzeichnet,**
**dass** bei reinem Außenluftbetrieb der Hohlraum (28) gegenüber dem zweiten Raum (42) verschlossen wird.

4. Verfahren nach Anspruch 1, wobei die wärmeerzeugenden Geräte in Reihen angeordnet sind,
**dadurch gekennzeichnet,**
**dass** die Kaltgänge (30a, 32b) von den Reihen (12, 14, 16, 18) begrenzt werden und Fortluft von dem ersten Raum (10) abgeführt wird.

5. Klimatisierungsanordnung umfassend einen zu klimatisierenden ersten Raum (10) mit diesen begrenzenden Kopf- und Seitenwandungen (20, 22) und einer Durchbrechungen aufweisenden und einen Hohlraum (28) begrenzenden Bodenwandung (26), einen fluiddurchströmten, insbesondere von Kaltwasser durchströmten, Wärmetauscher (24), der eine einen zweiten Raum (42) abtrennende Seitenwandung (22) oder ein Abschnitt dieser ist, in dem ersten Raum durch wärmeerzeugende Geräte voneinander getrennten zumindest einen Kaltraumbereich (31, 33, 30a, 32b) und zumindest einen Warmraumbereich (30, 32, 31a, 33b) sowie zumindest eine insbesondere in dem Hohlraum angeordnete eine Saugseite und eine Druckseite aufweisende Ventilatoreinrichtung (34, 36), wobei von der Saugseite Luft aus dem Warmbereich angesaugt und über die Druckseite Luft dem Kaltraumbereich zugeführt werden kann, **dadurch gekennzeichnet,**
**dass** der Hohlraum (28) oder der erste Raum (10) mit einer verschließbaren ersten Verschlusseinrichtung (56) für Fortluft verbunden ist oder eine solche aufweist, dass der zweite Raum (42) mit einer verschließbaren zweiten Verschlusseinrichtung (40) für Außenluft verbunden ist oder diese aufweist und die Außenluft mittels der Ventilatoreinrichtung in den Kaltraumbereich (31, 33, 30a, 32b) angesaugt wird und dass der erste Raum in Abhängigkeit von der in dem ersten Raum einzustellenden Temperatur im Umluftbetrieb, im reinen Außenluftbetrieb oder im Mischbetrieb klimatisierbar ist, wobei bei reinem Außenluftbetrieb die Außenluft unter Umgehung des Wärmetauschers dem ersten Raum zugeführt wird, wobei im Umluftbetrieb die Klimatisierung mit durch den Wärmetauscher strömender Luft erfolgt, und wobei im Mischbetrieb ein Teil der Abluft mit zuströmender Außenluft gemischt wird.

6. Klimatisierungsanordnung nach Anspruch 5,
**dadurch gekennzeichnet,**
**dass** die den Wärmetauscher (24) enthaltende Seitenwandung (22) eine verschließbare dritte Verschlusseinrichtung (48) für die Außenluft aufweist, über die Außenluft über den Kaltraumbereich (31, 33) und sodann den Warmraumbereich (30, 32) zu der ersten Verschlusseinrichtung (56) strömt.

7. Klimatisierungsanordnung nach Anspruch 5 oder 6,
**dadurch gekennzeichnet,**
**dass** der zweite Raum (42) mit dem Hohlraum (28) über eine verschließbare vierte Verschlusseinrichtung (44) verbunden ist.

8. Klimatisierungsanordnung nach einem der vorhergehenden Ansprüche 5 bis 7,
**dadurch gekennzeichnet,**
**dass** der erste Raum (10) mehrere von den wärmeerzeugenden Geräten begrenzte kopfseitig verschlossene Gänge (30, 32, 30a, 32b) bildende Warmraum- bzw. Kaltraumbereiche aufweist und dass vorzugsweise jedem Gang zumindest eine in dem Hohlraum (28) angeordnete Ventilatoreinrichtung (34, 36) zugeordnet ist.

## Claims

1. Method for air conditioning a first room (10), using a fan device (34, 36) having an intake and a discharge side, with front and side walls (20, 22) limiting the room, a bottom wall (26) having through-holes and limiting a cavity (28), and a heat exchanger (24) flowed through by fluid, in particular by cold water, which is a side wall (22) separating the first room from a second room (42) or is a section thereof, where the first room is divided by heat-generating devices into at least one cold room area (31, 33, 30a, 32b) and one warm room area (30, 32, 31a, 33b), where air can be sucked in from the warm area via the intake side of the fan device and air can be supplied to the cold room area via the discharge side,
wherein
the first room (10) is air-conditioned, depending on the temperature to be set therein, in recirculated-air mode, in outside-air-only mode or in mixed mode, where in outside-air-only mode and in mixed mode exhaust air is passed from the first room (10) or from the cavity (28) via an exhaust air opening closable by means of a first closing device (56), and outside air is supplied via an outside air opening provided in the second room (42) and closable by means of a second closing device (48), where in outside-air-only mode the outside air is supplied to the first room (10) and bypasses the heat exchanger, where in recirculated-air mode air-conditioning is achieved with air flowing through the heat exchanger, and where in mixed mode part of the exhaust air is mixed with inflowing outside air.

2. Method according to claim 1,
wherein
heat-generating devices are arranged in rows (12, 14, 16, 18) limiting aisles (30, 32) closed at the front, and in the aisles forming the warm room area the first closing device (56) closing the exhaust air opening extends from the cavity (28).

3. Method according to claim 1 or 2,
wherein
the cavity (28) is closed off from the second room (42) in outside-air-only mode.

4. Method according to claim 1, where the heat-generating devices are arranged in rows,
wherein
the cold aisles (30a, 32b) are limited by the rows (12, 14, 16, 18) and exhaust air is discharged from the first room (10).

5. Air conditioning arrangement comprising a first room (10) to be air-conditioned, with front and side walls (20, 22) limiting said room and a bottom wall (26) having through-holes and limiting a cavity (28), and a heat exchanger (24) flowed through by fluid, in particular by cold water, which is a side wall (22) separating a second room (42) or is a section thereof, and in the first room at least one cold room area (31, 33, 30a, 32b) and at least one warm room area (30, 32, 31a, 33b) separated from one another by heat-generating devices, and at least one fan device (34, 36) arranged in particular in the cavity and having an intake side and a discharge side, where air can be sucked in from the warm area via the intake side and air can be supplied to the cold room area via the discharge side,
wherein
the cavity (28) or the first room (10) is connected to or has a closable first closing device (56) for exhaust air, the second room (42) is connected to or has a closable second closing device (40) for outside air, and the outside air is sucked into the cold room area (31, 33, 30a, 32b) by means of the fan device and the first room is air-conditionable, depending on the temperate to be set in the first room, in recirculated-air mode, in outside-air-only mode or in mixed mode, where in outside-air-only mode the outside air is supplied to the first room and bypasses the heat exchanger, where in recirculated-air mode air-conditioning is achieved with air flowing through the heat exchanger, and where in mixed mode part of the exhaust air is mixed with inflowing outside air.

6. Air conditioning arrangement according to claim 5,
wherein
the side wall (22) containing the heat exchanger (24) has a closable third closing device (48) for the outside air, via which the outside air flows to the first closing device (56) via the cold room area (31, 33) and then the warm room area (30, 32).

7. Air conditioning arrangement according to claim 5 or 6,
wherein
the second room (42) is connected to the cavity (28) via a closable fourth closing device (44).

8. Air conditioning arrangement according to one of the preceding claims 5 to 7,
wherein
the first room (10) has several warm room and cold room areas limited by the heat-generating devices and forming aisles (30, 32, 30a, 32b) closed at the front, and preferably at least one fan device (34, 36) arranged in the cavity (28) is assigned to each aisle.

## Revendications

1. Procédé pour climatiser un premier local (10) en utilisant un dispositif à ventilateur (34, 36) présentant un côté d'aspiration et un côté de refoulement avec des parois frontales et latérales (20, 22) délimitant ledit local, une paroi inférieure (26) présentant des percées et délimitant un espace creux (28) ainsi qu'un échangeur thermique (24) traversé par un fluide, traversé notamment par de l'eau froide, qui constitue une paroi latérale (22) séparant le premier local du second (42) ou constitue une section de ladite paroi latérale, sachant que le premier local est divisé en au moins une zone de local froide (31, 33, 30a, 32b) et une zone de local chaude (30, 32, 31a, 33b) par des appareils produisant de la chaleur, sachant que de l'air peut être aspiré de la zone chaude par le biais du côté d'aspiration du dispositif à ventilateur et peut être distribué à la zone de local froide par le biais du côté de refoulement,
**caractérisé en ce**
**que** le premier local (10) est climatisé en fonction de la température à régler dans celui-ci en mode d'air recyclé, en mode d'air extérieur ou en mode mixte, sachant qu'en mode purement à air extérieur et en mode mixte, de l'air extrait est conduit hors du premier local (10) ou hors de l'espace creux (28) par le biais d'un orifice d'air extrait refermable au moyen d'un premier dispositif de fermeture (56) et que de l'air extérieur est distribué par le biais d'un orifice d'air extérieur situé dans le second local (42) et refermable au moyen d'un deuxième dispositif de fermeture (48), sachant qu'en mode purement à air extérieur, de l'air extérieur est distribué au premier local (10) en contournant l'échangeur thermique, sachant qu'en mode à air recyclé, la climatisation a lieu avec l'air traversant l'échangeur thermique et sachant qu'en mode mixte, une partie de l'air évacué est mélangée à de l'air extérieur affluant.

2. Procédé selon la revendication 1,
**caractérisé en ce**
**que** des appareils produisant de la chaleur sont disposés en rangées (12, 14, 16, 18) délimitant des corridors fermés côté frontal (30, 32) et qu'au niveau des corridors formant la zone de local chaude, le premier dispositif de fermeture (56) refermant l'orifice d'air extrait part de l'espace creux (28).

3. Procédé selon la revendication 1 ou 2,
**caractérisé en ce**
**qu'**en mode purement à air extérieur, l'espace creux (28) est fermé par rapport au second local (42).

4. Procédé selon la revendication 1, sachant que les appareils produisant de la chaleur sont disposés en rangées,
**caractérisé en ce**
**que** les corridors froids (30a, 32b) sont délimités par les rangées (12, 14, 16, 18) et que l'air extrait est évacué du premier local (10).

5. Dispositif de climatisation comprenant un premier local à climatiser (10) avec des parois frontales et latérales (20, 22) délimitant celui-ci et une paroi inférieure (26) présentant des percées et délimitant un espace creux (28), un échangeur thermique (24) traversé par un fluide, traversé notamment par de l'eau froide, qui constitue une paroi latérale (22) séparant un second local (42) ou constitue une section de ladite paroi latérale, au moins une zone de local froide (31, 33, 30a, 32b) et au moins une zone de local chaude (30, 32, 31a, 33b) séparées l'une de l'autre par des appareils produisant de la chaleur dans le premier local, ainsi qu'au moins un dispositif à ventilateur (34, 36) présentant un côté d'aspiration et un côté de refoulement et disposé notamment dans ledit espace creux, sachant que de l'air est aspiré de la zone chaude par le côté d'aspiration et que ledit air peut être distribué à la zone de local froide via le côté de refoulement,
**caractérisé en ce**
**que** l'espace creux (28) ou le premier local (10) est relié à un premier dispositif de fermeture (56) refermable pour l'air extrait ou présente ce type de dispositif, que le second local (42) est relié au deuxième dispositif de fermeture (40) refermable pour l'air extérieur ou présente un tel dispositif, et que l'air extérieur est aspiré dans la zone de local froide (31, 33, 30a, 32b) au moyen du dispositif à ventilateur et que le premier local est climatisable en fonction de la température à régler dans ledit premier local en mode à air recyclé, en mode purement à air extérieur ou en mode mixte, sachant qu'en mode purement à air extérieur, de l'air extérieur est distribué au premier local en contournant l'échangeur thermique, sachant qu'en mode à air recyclé, la climatisation est réalisée avec l'air traversant l'échangeur thermique et sachant qu'en mode mixte, une partie de l'air évacué est mélangée à de l'air extérieur affluant.

6. Dispositif de climatisation selon la revendication 5,
**caractérisé en ce**
**que** la paroi latérale (22) contenant l'échangeur thermique (24) présente un troisième dispositif de fermeture (48) refermable pour l'air extérieur, par le biais duquel de l'air extérieur passe par la zone de local froide (31, 33) et ensuite la zone de local chaude (30, 32) en direction du premier dispositif de fermeture (56).

7. Dispositif de climatisation selon la revendication 5 ou 6,
**caractérisé en ce**
**que** le second local (42) est relié à l'espace creux (28) par le biais d'un quatrième dispositif de fermeture (44) refermable.

8. Dispositif de climatisation selon une des revendications précédentes 5 à 7,
**caractérisé en ce**
**que** le premier local (10) présente plusieurs zones de local chaudes ou froides présentant des corridors (30, 32, 30a, 32b) fermés côté frontal, délimités par les appareils produisant de la chaleur et qu'au moins un dispositif à ventilateur (34, 36) disposé dans l'espace creux (28) est attribué de préférence à chaque corridor.
